# EUROPEAN PATENT APPLICATION

(11) **EP 4 096 036 A1**
(43) Date of publication of application: **30.11.2022**
(21) Application number: 21175974.1
(22) Date of filing: 26.05.2021
(51) Int. Cl.: H01S 5/0625, H01S 5/10, H01S 5/14, H01S 5/065

(54) **SEMICONDUCTOR RING LASER, PHOTONIC INTEGRATED CIRCUIT AND OPTO-ELECTRONIC SYSTEM COMPRISING THE SAME**

(71) Applicant: EFFECT Photonics B.V., 5616 LZ Eindhoven (NL)
(72) Inventor: Tahvili, Mohammad Saeed, 5616 LZ Eindhoven (NL)
(74) Representative: Kramer-Ograjensek, Petra

(57) **Abstract**

The invention relates to a semiconductor ring laser (1) comprising a closed loop laser cavity (2) and an optical gain device (3) that is optically interconnected with the closed loop laser cavity. The optical gain device comprises a first optical gain segment (4) and a second optical gain segment (5). The first optical gain segment and the second optical gain segment being non-identical, optically interconnected with each other, and electrically isolated from each other.

The invention also relates to a PIC (100) comprising a semiconductor ring laser according to the invention and to an opto-electronic system (200) that comprises such a PIC. The opto-electronic system can be one of a transmitter, a receiver, a transceiver, a coherent transmitter, a coherent receiver and a coherent transceiver. The opto-electronic system can for example, but not exclusively, be used for telecommunication applications, LIDAR or sensor applications.

## Description

### FIELD OF THE INVENTION

The present invention relates to a semiconductor ring laser. The invention also relates to a photonic integrated circuit (PIC) comprising the semiconductor ring laser according to the invention. The invention further relates to an opto-electronic system comprising a PIC according to the invention. The opto-electronic system according to the invention can be used for example, but not exclusively, for telecommunication applications, Light Detection and Ranging (LIDAR) or sensor applications.

### BACKGROUND OF THE INVENTION

In many opto-electronic systems that can be used for example, but not exclusively, for telecommunication applications, Light Detection and Ranging (LIDAR) or sensor applications, a semiconductor laser is the key element for generating a stable beam of optical radiation with a narrow spectrum. Many different types of semiconductor lasers are known. An advantage of applying a ring laser instead of for example a distributed Bragg reflector laser or a Fabry-Perot laser is that a ring laser does not require on-chip or facet reflectors. Instead a ring laser comprises a closed loop laser cavity. This has certain advantages for fabrication and design of advanced PICs and opto-electronic systems that require a semiconductor laser. The closed loop laser cavity is provided with an optical output coupler that acts as a power tap to extract a part of the optical power that is generated in the closed loop laser cavity as a result of stimulated emission of photons.

In general, round-trip conditions for both clockwise (CW) and counterclockwise (CCW) propagating optical waves are the same in the closed loop laser cavity of a semiconductor ring laser. Consequently, a semiconductor ring laser provides optical power in both CW and CCW directions. This effect is comparable with optical power emission from the front facet and the rear facet of a Fabry-Perot laser. In many applications it is important to control the ratio of the optical powers of the counter-propagating optical waves, i.e. the optical waves propagating in the CW and CCW directions.

A balance between the optical powers of the counter-propagating optical waves can be affected by unintentional asymmetries of the optical path of the closed loop laser cavity. Such asymmetries can be due to for example small fabrication errors, external feedback or optical radiation that is scattered back into the closed loop laser cavity. A fragile balance of the optical powers of the counter-propagating optical waves can cause instable optical performance of the semiconductor ring laser as a result of power exchange between the counter-propagating optical waves.

Based on the above, there is a need for providing a semiconductor ring laser having an improved optical performance due to improved control of the balance between the optical powers of the counter-propagating optical waves.

### SUMMARY OF THE INVENTION

It is an object of the present invention to provide a semiconductor ring laser that allows improved control of the balance between the optical powers of the counter-propagating optical waves as a result of which the semiconductor ring laser according to the invention can pre-empt or at least reduce at least one of the above-mentioned and/or other disadvantages associated with known semiconductor ring lasers.

It is another object of the present invention to provide a PIC comprising a semiconductor ring laser according to the invention.

It is yet another object of the present invention to provide an opto-electronic system comprising a PIC according to the invention. The opto-electronic system according to the invention can be used for example, but not exclusively, for telecommunication applications, LIDAR or sensor applications.

Aspects of the present invention are set out in the accompanying independent and dependent claims. Features from the dependent claims may be combined with features from the independent claim as appropriate and not merely as explicitly set out in the claims. Furthermore, all features may be replaced with other technically equivalent features.

At least one of the abovementioned objects is achieved by a semiconductor ring laser comprising:
- a closed loop laser cavity; and
- an optical gain device that is optically interconnected with the closed loop laser cavity, the optical gain device comprising:
   - a first optical gain segment; and
   - a second optical gain segment;
the first optical gain segment and the second optical gain segment being non-identical, optically interconnected with each other, and electrically isolated from each other.

By providing the semiconductor ring laser with the above-defined optical gain device, it is possible to enable an improved control of the balance between the optical powers of the optical waves that propagate in CW and CCW directions in the closed loop laser cavity. Consequently, an improved control of the directional operation of the semiconductor ring laser can be achieved.

The first optical gain segment, which for example can be associated with the optical waves propagating in the CW direction, and the second optical gain segment, which for example can be associated with the optical waves propagating in the CCW direction, are non-identical. As a result thereof, the symmetry of the round-trip condition for the optical waves propagating in the CW and CCW directions can be broken. Furthermore, due to the fact that the first optical gain segment and the second optical gain segment are electrically isolated from each other, they can be independently controlled.

As a result of the nonlinear optical gain saturation and/or compression of the non-identical and electrically independently controllable first and the second optical gain segments, it is possible to provide different round-trip gains for the optical waves propagating in the CW and CCW directions. By controlling a difference between the different round-trip gains for the optical waves propagating in the CW and CCW directions, one of the afore-mentioned directions can be designated as the dominant direction of operation. Consequently, the semiconductor ring laser according to the invention can have an improved directional operation.

By enabling an improved control of the directional operation of the semiconductor ring laser, the optical performance of the semiconductor ring laser according to the invention can be improved. The person skilled in the art will appreciate that by enabling the semiconductor ring laser to have a unidirectional operation, i.e. operation in the CW direction only or operation in the CCW direction only, the optical output power of the semiconductor ring laser can at least be increased and ultimately be maximized.

The semiconductor ring laser according to the invention can pre-empt disadvantages associated with a known solution for controlling the directional operation of semiconductor ring lasers that involves an optical feedback arm that is configured and arranged to suppress one of the two directions of operation, i.e. the CW or the CCW direction. A first disadvantage of the known solution is that the strength of the feedback signal is difficult to control. As a result, the laser can be prone to external feedback. A second disadvantage of the known solution is that if an amplitude control element is integrated in the feedback arm for controlling the strength of the feedback signal, the structure becomes larger and requires a larger footprint. As a result of a larger footprint, the costs of the semiconductor ring laser typically increase.

The person skilled in the art will appreciate that the semiconductor ring laser according to the present invention can pre-empt the above-mentioned first disadvantage associated with the known solution because controlling of the direction of operation, i.e. suppressing the undesired propagation direction, occurs within the laser cavity. Thus, external reflections do not couple back to the lasing mode via the feedback arm. As such, optical output power and frequency instabilities due to unwanted spurious optical reflections or power exchange between the counter-propagating optical waves, i.e. in the CW and CCW directions, can be suppressed. All of the foregoing is beneficial for achieving a semiconductor ring laser having an improved optical performance at least in terms of improved stability and reduced linewidth.

In an embodiment of the semiconductor ring laser according to the invention, the optical gain device is arranged in the closed loop laser cavity.

By arranging the optical gain device in the closed loop laser cavity, a compact embodiment of the semiconductor ring laser according to the invention can be provided. This is beneficial for reducing the footprint of the semiconductor ring laser and therefore for reducing the costs of the semiconductor ring laser. Based on the foregoing, the person skilled in the art will appreciate that the above-mentioned second disadvantage of the known solution that involves an optical feedback arm for controlling the directional operation of the semiconductor ring laser can be pre-empted by applying the above-defined embodiment of the semiconductor ring laser according to the present invention.

In an embodiment of the semiconductor ring laser according to the invention, the closed loop laser cavity comprises a ridge waveguide structure, the first optical gain segment being arranged at a first section of the ridge waveguide structure and the second optical gain segment being arranged at a second section of the ridge waveguide structure, the first section of the ridge waveguide structure having a different configuration than the second section of the ridge waveguide structure.

The first section and the second section of the ridge waveguide structure can have different configurations in terms of, for example, at least one of the transparency carrier densities of the first and second sections, the compositions of the semiconductor materials in the first and second sections, and the arrangement and/or the number of the layers of semiconductor materials in the first and second sections.

At least one of the afore-mentioned differences in the configurations of the first and second sections of the ridge waveguide structure can provide the first optical gain segment and the second optical gain segment of the optical gain device with different optical gain characteristics. As discussed above, the different optical gain characteristics of the first and second optical gain segments allow an improved control of the balance between the optical powers of the counter-propagating optical waves in the closed loop laser cavity and therefore an improved control of the directional operation of the semiconductor ring laser. As a result, the semiconductor ring laser according to the invention has an improved optical performance.

The person skilled in the art will appreciate that the ridge waveguide structure can be a closed loop structure having a so-called racetrack shape.

In an embodiment of the semiconductor ring laser according to the invention, the first section of the ridge waveguide structure and the second section of the ridge waveguide structure have different geometries.

The different geometries can for example be at least one of different lengths or widths of the first section and the second section of the ridge waveguide structure. It is also possible that the first section and the second section of the ridge waveguide structure are fabricated using different etch depths. In this way, a first optical gain segment and a second optical gain segment can be provided that are non-identical. As a result of the fact that the first and the second optical gain segments are non-identical, the symmetry of the closed loop laser cavity for the optical waves propagating in the CW and CCW directions can be broken. In addition, the first optical gain segment and the second optical gain segment can have different gain characteristics as a result of for example the above-mentioned different geometries of the first and the second sections of the ridge waveguide structure. As discussed above, in this way it is possible to achieve an improved control of the balance between the optical powers of the counter-propagating optical waves in the closed loop laser cavity and therefore an improved control of the directional operation of the semiconductor ring laser.

In an embodiment of the semiconductor ring laser according to the invention the first optical gain segment is provided with a first metal contact and the second optical gain segment is provided with a second metal contact, the first metal contact and the second metal contact being electrically isolated from each other, the first metal contact being electrically interconnectable with a first electrical biasing source and the second metal contact being electrically interconnectable with a second electrical biasing source, the first electrical biasing source and the second electrical biasing source being configured to provide electrical biasing conditions that are different from each other.

The person skilled in the art will appreciate that in this way it is also possible to provide the first optical gain segment and the second optical gain segment of the optical gain device with different gain characteristics in order to achieve an improved control of the balance between the optical powers of the counter-propagating optical waves in the closed loop laser cavity and therefore an improved control of the directional operation of the semiconductor ring laser.

The different electrical biasing conditions can for example be different electrical currents that are injected via the first metal contact and via the second metal contact in order to control the balance between the optical powers of the counter-propagating optical waves in the closed loop laser cavity. In this way, unidirectional operation of the semiconductor ring laser can be achieved and as a result thereof the optical output power of the semiconductor ring laser can at least be increased and ultimately be maximized.

An advantage of applying different electrical biasing conditions to the first and the second metal contacts is that depending on the actual applied electrical biasing conditions, it is possible to select and change the direction of operation. The person skilled in the art will appreciate that this is an advantage of the semiconductor ring laser according to the present invention as in accordance with the above-mentioned known solution in which an optical feedback arm is used, the direction of operation is fixed.

In addition, it is noted that in accordance with an exemplary, non-limiting embodiment of the semiconductor ring laser according to the present invention, the optical gain device can be a single structure that is divided into at least two optical gain segments that are non-identical, optically interconnected with each other, and electrically isolated from each other by way of the configurations and arrangements of the at least two electrical contacts that are used for individually driving the first and the second optical gain segments.

Furthermore, it is noted that in accordance with another exemplary, non-limiting embodiment of the semiconductor ring laser according to the present invention, the optical gain device can comprise three otherwise identical optical gain units that are electrically grouped together to obtain two non-identical gain segments. The non-identical optical gain segments are optically interconnected with each other and electrically isolated from each other. In order to achieve this, two identical optical gain units of the three identical optical gain units are electrically interconnected and electrically isolated from the third identical optical gain unit of the three identical optical gain units. The person skilled in the art will appreciate that in accordance with other exemplary, non-limiting embodiments of the semiconductor ring laser according to the invention the number of non-identical optical gain segments and the number of identical optical gain units can be any desired numbers. The above-mentioned numbers for the non-identical optical gain segments and for the identical optical gain units are mentioned by way of example only.

Regarding the above-mentioned exemplary, non-limiting embodiment of the semiconductor ring laser according to the invention, it is noted that the desired direction of operation, i.e. CW or CCW, can be established depending on the way in which the three identical optical gain units are electrically grouped together. For example, if two electrically interconnected identical optical gain units are associated with the optical waves that propagate in the CW direction, the CW direction will be the dominant direction of operation and the CCW direction will be suppressed. Similarly, if the two electrically interconnected identical optical gain units are associated with the optical waves that propagate in the CCW direction, the CCW direction will be the dominant direction of operation and the CW direction will be suppressed.

Moreover, it is noted that in accordance with other exemplary, non-limiting embodiments of the semiconductor ring laser according to the invention, any suitable combination of the above-mentioned options can be applied for providing the first optical gain segment and the second optical gain segment of the optical gain device with different gain characteristics and as a result thereof achieve an improved control of the directional operation of the semiconductor ring laser.

In an embodiment of the semiconductor ring laser according to the invention, the first optical gain segment comprises a first semiconductor optical amplifier (SOA) and the second optical gain segment comprises a second SOA.

The person skilled in the art will appreciate that SOAs are suitable devices for providing optical gain as by injecting current into the intrinsic region, which is often also referred to as the active region of the SOA, a large population of electrons and holes can be created. If the carrier density in the active region exceeds the transparency carrier density, then the SOA can achieve optical gain that can be used to amplify optical signals via stimulated emission.

As mentioned above, the first optical gain segment and the second optical gain segment of the optical gain device can comprise multiple SOAs, identical and/or non-identical, as long as the first optical gain segment and the second optical gain segment are non-identical.

In an embodiment of the semiconductor ring laser according to the invention, the semiconductor ring laser comprises an optical filter structure that is optically interconnected with the closed loop laser cavity, the optical filter structure being configured to have a bandpass filter characteristic with a predefined 3dB bandwidth and the closed loop laser cavity being configured to have a predefined mode spacing, wherein a ratio of the predefined 3dB bandwidth to the predefined mode spacing has a value in a range from 0.5 to 10.0.

It is noted that a bandpass filter characteristic for which the ratio of the predefined 3dB bandwidth to the predefined mode spacing of the closed loop laser cavity has a value in the above-mentioned range, is construed to be a narrow-width optical filter.

The optical filter structure can be a filter structure of any suitable type, for example a Mach-Zehnder filter, or of any suitable construction, for example a cascade of filter structures.

Furthermore, the person skilled in the art will appreciate that the actual value of the above-mentioned ratio of the predefined 3dB bandwidth to the predefined mode spacing can depend on the shape of the filter characteristic. For example, for a filter characteristic having a Gaussian shape or a raised-cosine shape the above-mentioned ratio can be 3.0, whereas for a filter characteristic having a block-shape the ratio can be 1.0.

It is noted that by optically interconnecting the optical filter structure and the closed loop laser cavity, it is possible to provide a single-mode semiconductor ring laser. In this case, the optical filter is designed such that the lasing spectrum contains a single, clean and stable wavelength or frequency that is required for modern applications, such as optical telecommunication systems. Furthermore, by concentrating the optical power in the designed direction, i.e. CW or CCW, as mentioned above, the optical output power of the semiconductor ring laser according to the invention can at least be increased and ultimately be maximized.

The person skilled in the art will appreciate that a compact embodiment of the single-mode semiconductor ring laser according to the invention can be provided by arranging the optical filter structure in the closed loop laser cavity. This is beneficial for reducing the footprint of the semiconductor ring laser and therefore for reducing the costs of the semiconductor ring laser.

In an embodiment of the semiconductor ring laser according to the invention, the optical filter structure is a tunable optical filter structure.

The person skilled in the art will appreciate that by adding a tunable filter structure in the closed loop laser cavity, it is possible to provide a single-mode, wavelength- or frequency-tunable semiconductor ring laser. By doing so, the lasing wavelength or lasing frequency can be selected by tuning the optical filter structure, while the risk of disturbing the directional operation of the semiconductor ring laser can at least be reduced as a result of reducing the directional optical power instabilities that can be caused by exchange of optical power between the optical waves that propagate in the CW and CCW directions.

In an embodiment of the semiconductor ring laser according to the invention, the semiconductor ring laser comprises an optical delay line that is optically interconnected with the closed loop laser cavity.

In this way, it is possible to provide a single-frequency or single-wavelength semiconductor ring laser having an extremely narrow linewidth. The person skilled in the art will appreciate that a compact embodiment of the single-frequency or single-wavelength semiconductor ring laser according to the invention can be provided by arranging the optical delay line in the closed loop laser cavity. This is beneficial for reducing the footprint of the semiconductor ring laser and therefore for reducing the costs of the semiconductor ring laser.

In an embodiment of the semiconductor ring laser according to the invention, the semiconductor ring laser is configured to allow hybrid integration or monolithic integration.

An advantage of configuring the semiconductor ring laser to allow hybrid integration with other opto-electronic devices is that the semiconductor ring laser according to the invention can also be used in the domain of silicon photonics.

Another advantage of enabling hybrid integration of the semiconductor ring laser according to the invention is that the semiconductor ring laser can be exchanged. Exchange of the semiconductor ring laser can for example be required in case of malfunction or after breakdown of the laser.

An advantage of configuring the semiconductor ring laser to allow monolithic integration with other opto-electronic devices is that both active and passive opto-electronic devices can be integrated on the same semiconductor substrate. As a result, monolithic integration of the active and passive opto-electronics devices can be less cumbersome and possibly requires less die area than the hybrid integration thereof. Consequently, the costs associated with monolithic integration of the active and the passive opto-electronic devices can be less than the costs associated with the hybrid integration thereof.

In an embodiment of the semiconductor ring laser according to the invention, the semiconductor ring laser is an indium phosphide, InP,-based ring laser.

The person skilled in the art will appreciate that InP-based semiconductor materials are the semiconductor materials of choice for fabricating a semiconductor ring laser that can be applied in optical telecommunication applications. In addition, the person skilled in the art will appreciate that InP-based ring lasers can advantageously be applied in LIDAR or sensor applications.

According to another aspect of the present invention, a PIC is provided comprising a semiconductor ring laser according to the invention.

Based on the above, the person skilled in the art will appreciate that the PIC according to the invention can benefit from the advantages provided by the semiconductor ring laser according to the present invention.

In an embodiment of the PIC according to the invention, the PIC is a monolithically integrated PIC.

As mentioned above, an advantage of monolithic integration is that both active and passive opto-electronic devices can be integrated on the same semiconductor substrate. As a result, fabrication of a monolithically integrated PIC can be less cumbersome and therefore can be less expensive than the assembly of a hybrid integrated PIC that requires assembly steps for the hybrid interconnection of the active and passive opto-electronic devices each of which typically are fabricated on different substrates. In addition, monolithic integration can allow the PIC to have a smaller footprint. The person skilled in the art will appreciate that a smaller footprint can allow the costs for the PIC to be reduced.

In an embodiment of the PIC according to the invention, the PIC is an InP-based PIC.

PICs that are applied for example, but not exclusively, in the field of optical telecommunication applications, LIDAR or sensor applications are becoming increasingly complex because of the increasing number of optical and electrical functions that are integrated on a single die that preferably has a footprint that is as small as possible. The person skilled in the art will appreciate that the most versatile technology platform for PICs, especially for the above-mentioned application areas, uses wafers comprising InP-based semiconductor materials. InP-based technology enables monolithic integration of both active components such as for example light-generating and/or light-absorbing optical devices, and passive components such as for example light-guiding and/or light-switching optical devices, in one PIC on a single die.

According to yet another aspect of the present invention, an opto-electronic system is provided comprising a PIC according to the invention. The opto-electronic system can for example, but not exclusively, be used for telecommunication applications, LIDAR or sensor applications. The opto-electronic system can be one of a transmitter, a receiver, a transceiver, a coherent transmitter, a coherent receiver and a coherent transceiver. Based on the above, the person skilled in the art will appreciate that any one of the above-mentioned transmitters, receivers and transceivers can benefit from the advantages provided by the PIC according to the present invention.

### BRIEF DESCRIPTION OF THE DRAWINGS

Further features and advantages of the invention will become apparent from the description of exemplary and non-limiting embodiments of an integrated semiconductor ring laser source, a PIC, and an opto-electronic system according to the present invention.

The person skilled in the art will appreciate that the described embodiments of the integrated semiconductor ring laser source, the PIC and the opto-electronic system are exemplary in nature only and not to be construed as limiting the scope of protection in any way. The person skilled in the art will realize that alternatives and equivalent embodiments of the integrated semiconductor ring laser source, the PIC and the opto-electronic system can be conceived and reduced to practice without departing from the scope of protection of the present invention.

Reference will be made to the figures on the accompanying drawing sheets. The figures are schematic in nature and therefore not necessarily drawn to scale. Furthermore, equal reference numerals denote equal or similar parts. On the attached drawing sheets,
figure 1 shows a schematic top view of a first exemplary, non-limiting embodiment of a semiconductor ring laser according to the present invention;
figure 2 shows a schematic cross-section of a first optical gain segment that is arranged at a first section of a ridge waveguide structure of the first exemplary, non-limiting embodiment of the semiconductor ring laser shown in figure 1;
figure 3 shows a schematic cross-section of a second optical gain segment that is arranged at a second section of the ridge waveguide structure of the first exemplary, non-limiting embodiment of the semiconductor ring laser shown in figure 1;
figure 4 shows a schematic top view of a second exemplary, non-limiting embodiment of the semiconductor ring laser according to the present invention;
figure 5 shows a schematic top view of a third exemplary, non-limiting embodiment of the semiconductor ring laser according to the present invention;
figure 6 shows a schematic top view of a fourth exemplary, non-limiting embodiment of the semiconductor ring laser according to the present invention;
figure 7 shows a schematic top view of a fifth exemplary, non-limiting embodiment of the semiconductor ring laser according to the present invention;
figure 8 shows a schematic top view of a sixth exemplary, non-limiting embodiment of the semiconductor ring laser according to the present invention;
figure 9 shows a schematic view of a first exemplary, non-limiting embodiment of a PIC according to the present invention that comprises the semiconductor ring laser according to the invention; and
figure 10 shows a schematic view of a first exemplary, non-limiting embodiment of an opto-electronic system according to the present invention that comprises the PIC according to the invention.

### DETAILED DESCRIPTION OF EMBODIMENTS

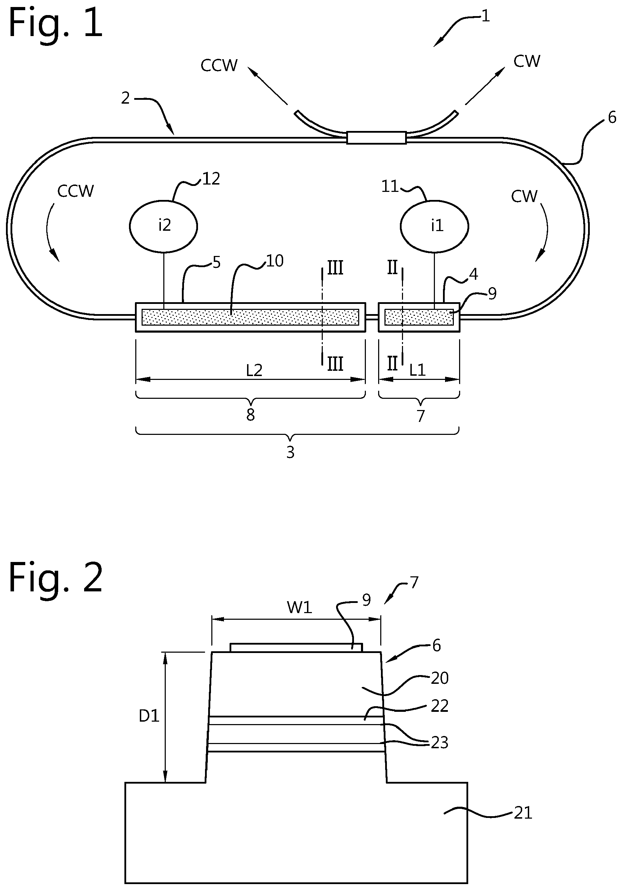

Figure 1 shows a schematic top view of a first exemplary, non-limiting embodiment of a semiconductor ring laser 1 according to the present invention that comprises a closed loop laser cavity 2 and an optical gain device 3 that is arranged in the closed loop laser cavity 2. By arranging the optical gain device 3 in the closed loop laser cavity 2, a compact embodiment of the semiconductor ring laser 1 according to the invention can be provided. This is beneficial for reducing the footprint of the semiconductor ring laser 1 and therefore for reducing the costs of the semiconductor ring laser.

The optical gain device 3 comprises a first optical gain segment 4 and a second optical gain segment 5. The first optical gain segment 4 and the second optical gain segment 5 are non-identical, optically interconnected with each other, and electrically isolated from each other.

The optical gain device 3 enables an improved control of the balance between the optical powers of the optical waves that propagate in CW and CCW directions in the closed loop laser cavity 2. The CW and CCW direction are indicated in figure 1 with curved arrows. Consequently, an improved control of the directional operation of the semiconductor ring laser 1 can be achieved.

The first optical gain segment 4, which for example can be associated with the optical waves propagating in the CW direction, and the second optical gain segment 5, which for example can be associated with the optical waves propagating in the CCW direction, are non-identical. As a result thereof, the symmetry of the round-trip condition for the optical waves propagating in the CW and CCW directions can be broken. Furthermore, due to the fact that the first optical gain segment 4 and the second optical gain segment 5 are electrically isolated from each other, they can be independently controlled.

As discussed above, due to the nonlinear optical gain saturation and/or compression of the non-identical and electrically independently controllable first optical gain segment 4 and the second optical gain segment 5, it is possible to provide different round-trip gains for the optical waves propagating in the CW and CCW directions. By controlling a difference between the different round-trip gains for the optical waves propagating in the CW and CCW directions, one of the afore-mentioned directions can be designated as the dominant direction of operation. Consequently, the semiconductor ring laser 1 according to the invention can have an improved directional operation.

By enabling an improved control of the directional operation of the semiconductor ring laser 1, the optical performance of the semiconductor ring laser 1 according to the invention can be improved. The person skilled in the art will appreciate that by enabling the semiconductor ring laser 1 to have a unidirectional operation, i.e. operation in the CW direction only or operation in the CCW direction only, the optical output power of the semiconductor ring laser 1 can at least be increased and ultimately be maximized.

The closed loop laser cavity 2 of the semiconductor ring laser 1 shown in figure 1 comprises a closed loop ridge waveguide structure 6 having a so-called racetrack shape.

The first optical gain segment 4 is arranged at a first section 7 of the ridge waveguide structure 6 and the second optical gain segment 5 is arranged at a second section 8 of the ridge waveguide structure 6.

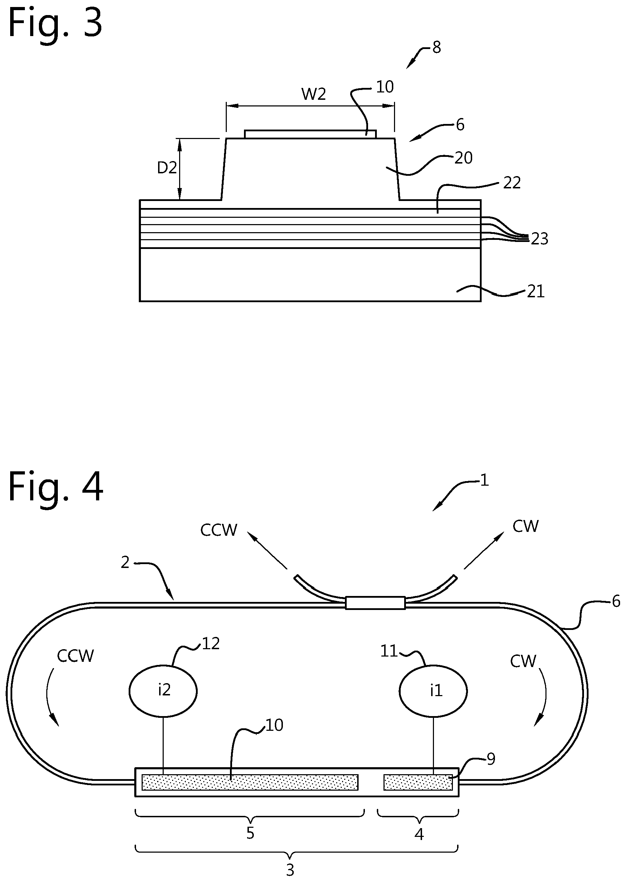

Figure 2 shows a schematic cross-section of the first optical gain segment 4 that is arranged at the first section 7 of the ridge waveguide structure 6, whereas figure 3 shows a schematic cross-section of the second optical gain segment 5 that is arranged at the second section 8 of the ridge waveguide structure 6 as is shown in figure 1.

Although figures 2 and 3 are schematic in nature only, the dimensions in figures 2 and 3 are drawn on a same scale. Therefore, the dimensions of the features shown in figures 2 and 3 are comparable.

In accordance with the first exemplary, non-limiting embodiment of the first section 7 of the ridge waveguide structure 6 shown in figure 2, the first section 7 comprises a semiconductor-based top cladding layer 20, a semiconductor-based bottom cladding layer 21, and a semiconductor-based optical core layer 22 that is arranged between and in contact with the semiconductor-based top cladding layer 20 and the semiconductor-based bottom cladding layer 21. The semiconductor-based optical core layer 22 is provided with two quantum wells 23.

In accordance with the first exemplary, non-limiting embodiment of the second section 8 of the ridge waveguide structure 6 shown in figure 3, the second section 8 comprises a semiconductor-based top cladding layer 20, a semiconductor-based bottom cladding layer 21, and a semiconductor-based optical core layer 22 that is arranged between and in contact with the semiconductor-based top cladding layer 20 and the semiconductor-based bottom cladding layer 21. The semiconductor-based optical core layer 22 is provided with more than two quantum wells 23, in this example with four quantum wells.

From a comparison of figures 2 and 3, it can be observed that the first section 7 of the ridge waveguide structure 6 has a different configuration than the second section 8 of the ridge waveguide structure 6 at least in terms of the number of quantum wells of the semiconductor-based optical core layers 22 in the first section 7 and the second section 8, respectively.

It is noted that in accordance with other exemplary, non-limiting embodiments of the first section 7 and the second section 8 of the ridge waveguide structure 6 that are not shown, it is possible to provide the first section 7 and of the second section 8 with different configurations in terms of, for example, the transparency carrier densities of the first and second sections and/or the compositions of the semiconductor materials in the first and second sections.

The person skilled in the art will appreciate that InP-based semiconductor materials are the semiconductor materials of choice for fabricating a semiconductor ring laser that can be applied in optical telecommunication applications. In addition, the person skilled in the art will appreciate that InP-based ring lasers can advantageously be applied in LIDAR or sensor applications.

At least one of the afore-mentioned differences in the configurations of the first section 7 and the second section 8 of the ridge waveguide structure 6 can provide the first optical gain segment 4 and the second optical gain segment 5 of the optical gain device 3 with different optical gain characteristics. As discussed above, the different optical gain characteristics of the first and second optical gain segments allow an improved control of the balance between the optical powers of the counter-propagating optical waves in the closed loop laser cavity 2 and therefore an improved control of the directional operation of the semiconductor ring laser 1. As a result, the semiconductor ring laser 1 according to the invention has an improved optical performance.

Furthermore, from a comparison of figures 2 and 3 it can also be observed that the first exemplary, non-limiting embodiment of the first section 7 and the first exemplary, non-limiting embodiment of the second section 8 of the ridge waveguide structure 6 have different geometries. Although the first section 7 has a first width *W*1 that is the same as a second width *W*2 of the second section 8, the person skilled in the art will appreciate that in accordance with other exemplary, non-limiting embodiments, the first section 7 and the second section 8 can have different widths. This results in different optical confinement of the guided optical radiation in the first section 7 and the second section 8 of the ridge waveguide structure 6.

In accordance with the exemplary, non-limiting first exemplary embodiments of the first section 7 and the second section 8 as shown in figures 2 and 3 respectively, the first section 7 of the ridge waveguide structure 6 is fabricated using an etch depth *D*1 that is larger than the etch depth *D*2 that is used for fabricating the second section 8 of the ridge waveguide structure 6. In the first section 7 of the ridge waveguide structure 6, the first etch depth *D*1 has resulted in the partial removal of the semiconductor-based top cladding layer 20, the semiconductor-based optical core layer 22 and the semiconductor-based bottom cladding layer 21. In the second section 8 of the ridge waveguide structure 6, the second etch depth *D*2 has resulted in the partial removal of only the semiconductor-based top cladding layer 20. The person skilled in the art will appreciate that the degree of optical confinement that is provided by the first section 7 of the ridge waveguide structure 6 is higher than the degree of optical confinement that is provided by the second section 8 of the ridge waveguide structure 6.

From figure 1 it can be observed that the first section 7 has a first length *L*1 that is different than a second length *L*2 of the second section 8. The person skilled in the art will appreciate that as a result of the different geometries of the first section 7 and the second section 8 of the ridge waveguide structure 6 as discussed above, the first optical gain segment 4 and the second optical gain segment 5 are non-identical. Furthermore, as a result of the fact that the first optical gain segment 4 and the second optical gain segment 5 are non-identical, the symmetry of the closed loop laser cavity 2 for the optical waves propagating in the CW and CCW directions is broken. In addition, the first optical gain segment 4 and the second optical gain segment 5 can have different gain characteristics as a result of the different geometries of the first section 7 and the second section 8 of the ridge waveguide structure 6. As discussed above, in this way it is possible to achieve an improved control of the balance between the optical powers of the counter-propagating optical waves in the closed loop laser cavity 2 and therefore an improved control of the directional operation of the semiconductor ring laser 1.

Figure 1 shows that the first optical gain segment 4 is provided with a first metal contact 9 and that the second optical gain segment 5 is provided with a second metal contact 10. The first metal contact 9 and the second metal contact 10 are electrically isolated from each other. The first metal contact 9 is electrically interconnected with a first electrical biasing source 11 and the second metal contact 10 is electrically interconnected with a second electrical biasing source 12.

The first electrical biasing source 11 and the second electrical biasing source 12 are configured to provide electrical biasing conditions that are different from each other. The person skilled in the art will appreciate that in this way it is also possible to provide the first optical gain segment 4 and the second optical gain segment 5 of the optical gain device 3 with different gain characteristics in order to achieve an improved control of the balance between the optical powers of the counter-propagating optical waves in the closed loop laser cavity 2 and therefore an improved control of the directional operation of the semiconductor ring laser 1.

The different electrical biasing conditions can for example be different electrical currents that are injected via the first metal contact 9 and via the second metal contact 10 in order for controlling the balance between the optical powers of the counter-propagating optical waves in the closed loop laser cavity 2. In this way, unidirectional operation of the semiconductor ring laser 1 can be achieved and as a result thereof, the optical output power of the semiconductor ring laser 1 can at least be increased and ultimately be maximized.

An advantage of applying different electrical biasing conditions to the first metal contact 9 and the second metal contact 10 is that depending on the actual applied electrical biasing conditions, it is possible to select and change the direction of operation.

Figure 4 shows a schematic top view of a second exemplary, non-limiting embodiment of the semiconductor ring laser 1 according to the present invention. The optical gain device 3 is a single structure that is divided into a first optical gain segment 4 and a second optical gain segment 5 that are non-identical, optically interconnected with each other, and electrically isolated from each other by way of the configurations and arrangements of the first metal contact 9 and the second metal contact 10 that are used for individually driving the first optical gain segment 4 and the second optical gain segment 5.

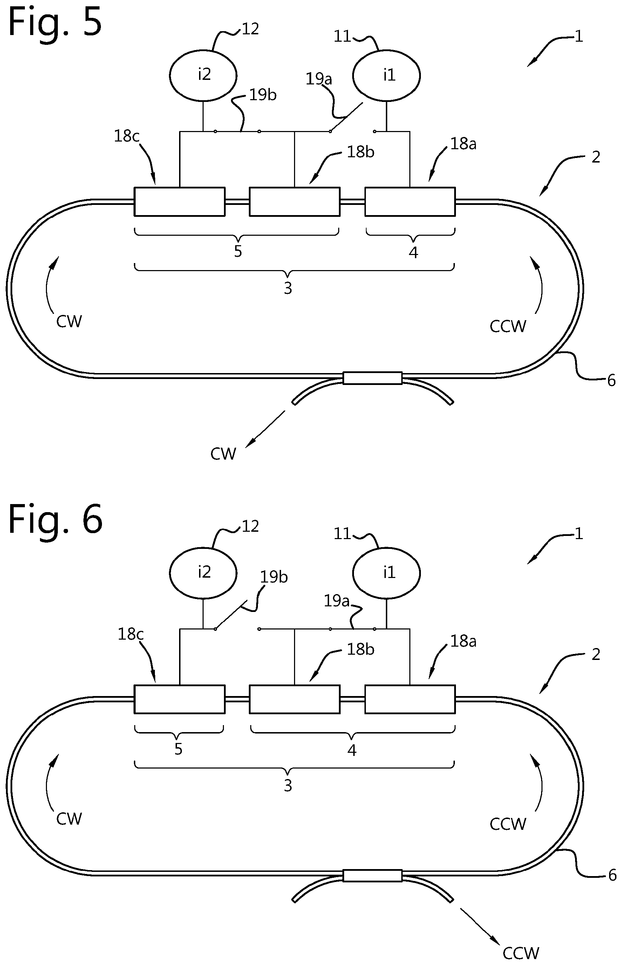

Figure 5 shows a schematic top view of a third exemplary, non-limiting embodiment of the semiconductor ring laser 1 according to the present invention, wherein the optical gain device 3 comprises three otherwise identical optical gain units 18a, 18b, 18c that are electrically grouped together using two electrical switches 19a, 19b to obtain the non-identical first optical gain segment 4 that comprises the first optical gain unit 18a of the three identical optical gain units and the second optical gain segment 5 that comprises the second optical gain unit 18b and third optical gain unit 18c of the three identical optical gain units.

The first optical gain segment 4 and the second optical gain segment 5 are optically interconnected with each other and electrically isolated from each other. The first optical gain unit 18a of the first optical gain segment 4 is electrically connected to a first electrical biasing source 11 that is configured to inject electrical current into first optical gain unit 18a. The second optical gain unit 18b and the third optical gain unit 18c of the second optical gain segment 5 are electrically connected to a second electrical biasing source 12 that is configured to inject electrical current into the second optical gain unit 18b and the third optical gain unit 18c. It is noted that by effectively pumping the second optical gain unit 18b and the third optical gain unit 18c in parallel, the second optical gain segment 5 is longer than the first optical gain segment 4. As a result of the larger round-trip gain provided by the second optical gain unit 5, the CW direction will be the dominant direction of operation and the CCW direction will be suppressed.

Figure 6 shows a schematic top view of a fourth exemplary, non-limiting embodiment of the semiconductor ring laser 1 according to the present invention, wherein the optical gain device 3 also comprises three otherwise identical optical gain units 18a, 18b, 18c that are electrically grouped together using two electrical switches 19a, 19b to obtain the non-identical first optical gain segment 4 that comprises the first optical gain unit 18a and the second optical gain unit 18b of the three identical optical gain units and the second optical gain segment 5 that comprises the third optical gain unit 18c of the three identical optical gain units.

The first optical gain segment 4 and the second optical gain segment 5 are optically interconnected with each other and electrically isolated from each other. The first optical gain unit 18a and the second optical gain unit 18b of the first optical gain segment 4 are electrically connected to the first electrical biasing source 11 that is configured to inject electrical current into the first optical gain unit 18a and the second optical gain unit 18b. The third optical gain unit 18c of the second optical gain segment 5 is electrically connected to the second electrical biasing source 12 that is configured to inject electrical current into the third optical gain unit 18c. It is noted that by effectively pumping the first optical gain unit 18a and the second optical gain unit 18b in parallel, the first optical gain segment 4 is longer than the second optical gain segment 5. As a result of the larger round-trip gain provided by the first optical gain unit 4, the CCW direction will be the dominant direction of operation and the CW direction will be suppressed.

It is noted that in accordance with other exemplary, non-limiting embodiments (not shown) of the semiconductor ring laser according to the invention, any suitable combination of the above-mentioned embodiments can be applied for achieving an improved control of the directional operation of the semiconductor ring laser.

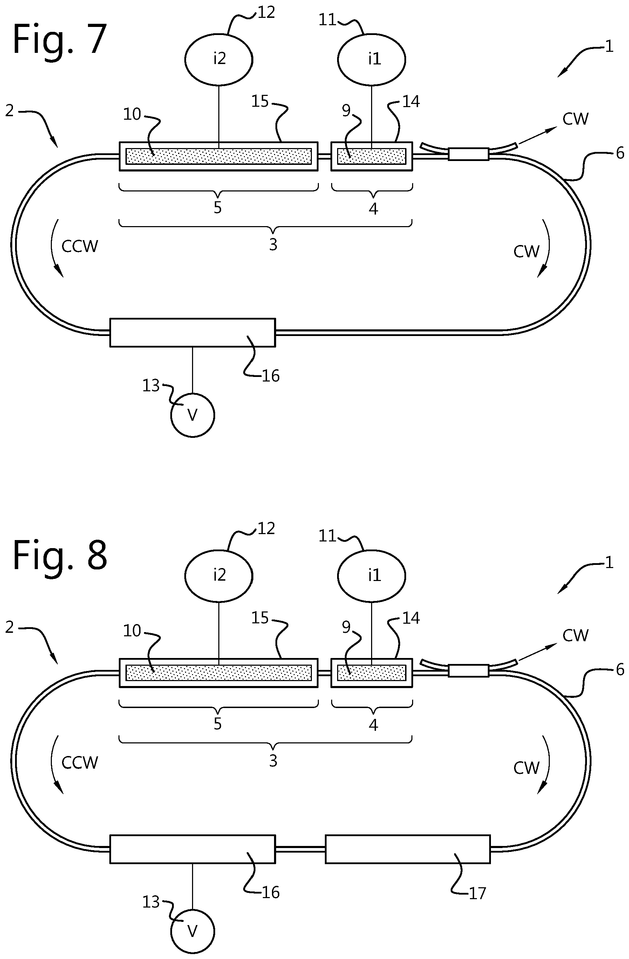

Figure 7 shows a schematic top view of a fifth exemplary, non-limiting embodiment of the semiconductor ring laser 1 according to the present invention, wherein an optical filter structure 16 is optically interconnected with the closed loop laser cavity 2. The optical filter structure 16 has a bandpass filter characteristic with a predefined 3dB bandwidth and the closed loop laser cavity 2 has a predefined mode spacing, wherein a ratio of the predefined 3dB bandwidth to the predefined mode spacing has a value in a range from 0.5 to 10.0.

It is noted that a bandpass filter characteristic for which the ratio of the predefined 3dB bandwidth to the predefined mode spacing of the closed loop laser cavity 2 has a value in the above-mentioned range, is construed to be a narrow-width optical filter.

The optical filter structure 16 can be a filter structure of any suitable type, for example a Mach-Zehnder filter, or of any suitable construction, for example a cascade of filter structures.

Furthermore, the person skilled in the art will appreciate that the actual value of the above-mentioned ratio of the predefined 3dB bandwidth to the predefined mode spacing can depend on the shape of the filter characteristic. For example, for a filter characteristic having a Gaussian shape or a raised-cosine shape the above-mentioned ratio can be 3.0, whereas for a filter characteristic having a block-shape the ratio can be 1.0.

It is noted that by optically interconnecting the optical filter structure 16 and the closed loop laser cavity 2, it is possible to provide a single-mode semiconductor ring laser 1. In this case, the optical filter 16 is designed such that the lasing spectrum contains a single, clean and stable wavelength or frequency that is required for modern applications, such as optical telecommunication systems. Furthermore, by concentrating the optical power in the designed direction, i.e. CW or CCW, as mentioned above, the optical output power of the semiconductor ring laser 1 can at least be increased and ultimately be maximized.

The person skilled in the art will appreciate that the embodiment of the single-mode semiconductor ring laser 1 shown in figure 7 is compact as a result of arranging the optical filter structure 16 in the closed loop laser cavity 2. This is beneficial for reducing the footprint of the semiconductor ring laser and therefore for reducing the costs of the semiconductor ring laser.

By adding a tunable filter structure 16 in the closed loop laser cavity 2 that is electrically interconnected with a third electrical biasing source 13, it is possible to provide a single-mode, wavelength- or frequency-tunable semiconductor ring laser 1. The third electrical biasing source 13 is configured to enable tuning of the optical filter structure 16, thereby selecting the lasing wavelength or lasing frequency of the semiconductor ring laser 1, while the risk of disturbing the directional operation of the semiconductor ring laser 1 can at least be reduced as a result of reducing the directional optical power instabilities that can be caused by exchange of optical power between the optical waves that propagate in the CW and CCW directions.

In the exemplary, non-limiting embodiment of the semiconductor ring laser 1 shown in figure 7, the first optical gain segment 4 of the optical gain device 3 comprises a first SOA 14 and the second optical gain segment 5 of the optical gain device 3 comprises a second SOA 15. As the second SOA 15 is larger than the first SOA 14, the round-trip gain provided by the second optical gain segment 5 is larger than the round-trip gain provided by the first optical gain segment 4. In this case, the CCW direction will be the dominant direction of operation and the CW direction will be suppressed.

It is noted that in accordance with other exemplary, non-limiting embodiments (not shown) of the semiconductor ring laser, the first optical gain segment and the second optical gain segment of the optical gain device can comprise multiple SOAs, identical and/or non-identical, as long as the first optical gain segment and the second optical gain segment are non-identical.

Figure 8 shows a schematic top view of a sixth exemplary, non-limiting embodiment of the semiconductor ring laser 1, wherein an optical delay line 17 is optically interconnected with the closed loop laser cavity 2. In this way, it is possible to provide a single-frequency semiconductor ring laser 1 having an extremely narrow linewidth. By arranging the optical delay line 17 in the closed loop laser cavity 2, the embodiment of the single-frequency semiconductor ring laser 1 person is compact. This is beneficial for reducing the footprint of the semiconductor ring laser and therefore for reducing the costs of the semiconductor ring laser.

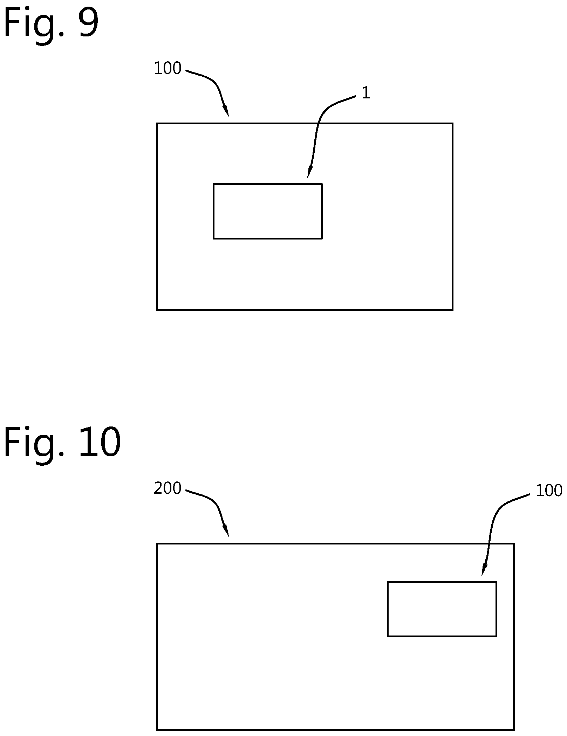

Figure 9 shows a schematic view of a first exemplary, non-limiting embodiment of the PIC 100 according to the present invention that comprises the semiconductor ring laser 1 according to the invention. The semiconductor ring laser 1 can be construed to be monolithically integrated with the other opto-electronic devices (not shown) of the PIC 100.

In accordance with an exemplary, non-limiting embodiment of the PIC that is not shown, the semiconductor ring laser can be integrated in a hybrid way with the other opto-electronic devices of the PIC. An advantage of enabling hybrid integration of the semiconductor ring laser according to the invention is that the semiconductor ring laser can also be used in the domain of silicon photonics. Another advantage of enabling hybrid integration of the semiconductor ring laser according to the invention is that the semiconductor ring laser can be exchanged. Exchange of the semiconductor ring laser can for example be required in case of malfunction or after breakdown of the laser.

An advantage of monolithically integrating the semiconductor ring laser with other opto-electronic devices (not shown) on the same substrate as schematically illustrated in figure 9, is that the monolithic integration of the semiconductor ring laser 1 and the other opto-electronic components can be less cumbersome and possibly requires less die area than the hybrid integration thereof. Consequently, the costs associated with monolithic integration of the active and the passive opto-electronic devices can be less than the costs associated with the hybrid integration thereof. In addition, monolithic integration can allow the PIC 100 to have a smaller footprint. This is beneficial for reducing the costs of the PIC.

The PIC 100 can be an InP-based PIC. The person skilled in the art will appreciate that the most versatile technology platform for PICs, especially for the above-mentioned application areas, uses wafers comprising InP-based semiconductor materials. InP-based technology enables monolithic integration of both active components such as for example light-generating and/or light-absorbing optical devices, and passive components such as for example light-guiding and/or light-switching optical devices, in one PIC on a single die.

Based on the above, the person skilled in the art will appreciate that the PIC 100 according to the invention can benefit from the advantages provided by the semiconductor ring laser 1 according to the present invention.

Figure 10 shows a schematic view of a first exemplary, non-limiting embodiment of an opto-electronic system 200 according to the present invention that comprises a PIC 100 according to the invention. The opto-electronic system 200 can be used for example but not exclusively for telecommunication applications, LIDAR or sensor applications. The opto-electronic system 200 can for example be one of a transmitter, a receiver, a transceiver, a coherent transmitter, a coherent receiver and a coherent transceiver. Based on the above, the person skilled in the art will appreciate that the opto-electronic system 200 according to the present invention can benefit from the advantages provided by the PIC 100 according to the present invention.

The present invention can be summarized as relating to a semiconductor ring laser 1 comprising a closed loop laser cavity 2 and an optical gain device 3 that is optically interconnected with the closed loop laser cavity 2. The optical gain device 3 comprises a first optical gain segment 4 and a second optical gain segment 5. The first optical gain segment 4 and the second optical gain segment 5 being non-identical, optically interconnected with each other, and electrically isolated from each other.

The invention also relates to a PIC 100 comprising a semiconductor ring laser 1 according to the invention and to an opto-electronic system 200 that comprises such a PIC 100. The opto-electronic system 200 can be one of a transmitter, a receiver, a transceiver, a coherent transmitter, a coherent receiver and a coherent transceiver. The opto-electronic system 200 can for example, but not exclusively, be used for telecommunication applications, LIDAR or sensor applications.

It will be clear to a person skilled in the art that the scope of the present invention is not limited to the examples discussed in the foregoing but that several amendments and modifications thereof are possible without deviating from the scope of the present invention as defined by the attached claims. In particular, combinations of specific features of various aspects of the invention may be made. An aspect of the invention may be further advantageously enhanced by adding a feature that was described in relation to another aspect of the invention. While the present invention has been illustrated and described in detail in the figures and the description, such illustration and description are to be considered illustrative or exemplary only, and not restrictive.

The present invention is not limited to the disclosed embodiments. Variations to the disclosed embodiments can be understood and effected by a person skilled in the art in practicing the claimed invention, from a study of the figures, the description and the attached claims. In the claims, the word "comprising" does not exclude other steps or elements, and the indefinite article "a" or "an" does not exclude a plurality. The mere fact that certain measures are recited in mutually different dependent claims does not indicate that a combination of these measures cannot be used to advantage. Any reference numerals in the claims should not be construed as limiting the scope of the present invention.

### REFERENCE NUMERALS

- 1: semiconductor ring laser
- 2: closed loop laser cavity
- 3: optical gain device
- 4: first optical gain segment
- 5: second optical gain segment
- 6: ridge waveguide structure
- 7: first section of the ridge waveguide structure
- 8: second section of the ridge waveguide structure
- 9: first metal contact
- 10: second metal contact
- 11: first electrical biasing source
- 12: second electrical biasing source
- 13: third electrical biasing source
- 14: first semiconductor optical amplifier (SOA)
- 15: second SOA
- 16: optical filter structure
- 17: optical delay line
- 18a,18b,18c: identical optical gain units
- 19a, 19b: electrical switches
- 20: semiconductor-based top cladding layer
- 21: semiconductor-based bottom cladding layer
- 22: semiconductor-based optical core layer
- 23: quantum well
- 100: photonic integrated circuit (PIC)
- 200: opto-electronic system
- *D1, D*2: etch depths of respectively the first and the second sections of the ridge waveguide structure
- *L*1, *L*2: lengths of respectively the first and the second sections of the ridge waveguide structure
- *W1, W2*: widths of respectively the first and the second sections of the ridge waveguide structure

## Claims

1. A semiconductor ring laser (1) comprising:
- a closed loop laser cavity (2); and
- an optical gain device (3) that is optically interconnected with the closed loop laser cavity (2), the optical gain device (3) comprising:
• a first optical gain segment (4); and
• a second optical gain segment (5);
the first optical gain segment (4) and the second optical gain segment (5) being non-identical, optically interconnected with each other, and electrically isolated from each other.

2. The semiconductor ring laser (1) according to claim 1, wherein the optical gain device (3) is arranged in the closed loop laser cavity (2).

3. The semiconductor ring laser (1) according to claim 1 or 2, wherein the closed loop laser cavity (2) comprises a ridge waveguide structure (6), the first optical gain segment (4) being arranged at a first section (7) of the ridge waveguide structure (6) and the second optical gain segment (5) being arranged at a second section (8) of the ridge waveguide structure (6), the first section (7) of the ridge waveguide structure (6) having a different configuration than the second section (8) of the ridge waveguide structure (6).

4. The semiconductor ring laser (1) according to claim 3, wherein the first section (7) of the ridge waveguide structure (6) and the second section (8) of the ridge waveguide structure (6) have different geometries.

5. The semiconductor ring laser (1) according to any one of the claims 1 to 4, wherein the first optical gain segment (4) is provided with a first metal contact (9) and the second optical gain segment (5) is provided with a second metal contact (10), the first metal contact (9) and the second metal contact (10) being electrically isolated from each other, the first metal contact (9) being electrically interconnectable with a first electrical biasing source (11) and the second metal contact (10) being electrically interconnectable with a second electrical biasing source (12), the first electrical biasing source (11) and the second electrical biasing source (12) being configured to provide electrical biasing conditions that are different from each other.

6. The semiconductor ring laser (1) according to any one of the claims 1 to 5, wherein the first optical gain segment (4) comprises a first semiconductor optical amplifier, SOA, (14) and the second optical gain segment comprises a second SOA (15).

7. The semiconductor ring laser (1) according to any one of the claims 1 to 6, comprising an optical filter structure (16) that is optically interconnected with the closed loop laser cavity (2), the optical filter structure (16) being configured to have a bandpass filter characteristic with a predefined 3dB bandwidth and the closed loop laser cavity (2) being configured to have a predefined mode spacing, wherein a ratio of the predefined 3dB bandwidth to the predefined mode spacing has a value in a range from 0.5 to 10.0.

8. The semiconductor ring laser (1) according to claim 7, wherein the optical filter structure (16) is a tunable optical filter structure.

9. The semiconductor ring laser (1) according to any one of the claims 1 to 8, comprising an optical delay line (17) that is optically interconnected with the closed loop laser cavity (2).

10. The semiconductor ring laser (1) according to any one of the claims 1 to 9, wherein the semiconductor ring laser (1) is configured to allow hybrid integration or monolithic integration.

11. The semiconductor ring laser (1) according to any one of the claims 1 to 10, wherein the semiconductor ring laser is an indium phosphide, InP,-based ring laser.

12. A photonic integrated circuit, PIC, (100) comprising a semiconductor ring laser (1) according to any one of the claims 1 to 11.

13. The PIC (100) according to claim 12, wherein the PIC is a monolithically integrated PIC.

14. The PIC (100) according to claim 12 or 13, wherein the PIC is an InP-based PIC.

15. An opto-electronic system (200) comprising a PIC (100) according to any one of the claims 12 to 14, wherein the opto-electronic system (200) is one of a transmitter, a receiver, a transceiver, a coherent transmitter, a coherent receiver and a coherent transceiver.
